# EUROPÄISCHE PATENTSCHRIFT

(11) **EP 1 180 486 B1**
(45) Veröffentlichungstag und Bekanntmachung des Hinweises auf die Patenterteilung: **10.09.2003**
(21) Anmeldenummer: 01115993.6
(22) Anmeldetag: 30.06.2001
(51) Int. Cl.: H02N 1/00, B65G 51/03, B65G 54/02

(54) **Fördereinrichtung für den berührungslosen Transport von Bauteilen**
Contact free conveying apparatus for transporting items
Dispositif de transport d'éléments sans contact

(30) Priorität: 08.08.2000 DE 10038611
(43) Veröffentlichungstag der Anmeldung: 20.02.2002
(73) Patentinhaber: Forschungszentrum Karlsruhe GmbH, 76133 Karlsruhe (DE)
(72) Erfinder: Gengenbach, Ulrich, Dr., 75196 Remchingen (DE); Boole, James Charles, Perrycrofts, Tampworth, Staffs B79 8TU (GB)

(56) Entgegenhaltungen:
- EP-A- 0 198 518
- EP-A- 0 287 838
- DE-A- 4 437 224
- US-A- 4 949 950
- PATENT ABSTRACTS OF JAPAN vol. 010, no. 253 (M-512), 29. August 1986 (1986-08-29) & JP 61 081324 A (SHINKO ELECTRIC CO LTD), 24. April 1986 (1986-04-24)

## Beschreibung

Die Erfindung betrifft eine elektronisch betriebene Fördereinrichtung für den berührungslosen Transport von Kunststoff- oder Metallbauteilen (siehe z.B. das Dokument EP-A-0 287 838).

Die Bauteile sind von einer Dimension derart, daß sie mittels Luftkissen oder Elektrostatik oder aus einer kombinierten Anwendung von beidem in technischen Fertigungsbereichen zu einem Zusammenbauort berührungslos transportiert werden können. Kunststoffbauteile werden durch das Feld polarisiert. Bei Metallbauteilen werden die Ladungen durch Influenz getrennt. Die so erzeugte Ladung auf dem Bauteil wird von dem Feld der Elektroden angezogen bzw. abgestoßen. Durch entsprechende Beschaltung der Elektroden also räumliche Wanderung eines elektrischen Potentialzustands kann das Bauteil aufgrund einer Art Dipolausbildung schrittweise vorwärts transportiert, d.h. vorwärts geschoben oder gestoßen werden.

In JP 7337038A wird ein Luftkissen zur Levitation des Läufers eines elektrostatischen Aktors verwendet. Der Stator hat eine schichtartige Struktur aus einem Elektrodengefüge, bei dem Leiterdrähte und Fasern wie Ketten- und Schußfäden gewebt sind. Er besteht weiter aus einer porösen Platte, durch welche Luft strömt. Während des Antriebs, wird trockene Luft durch eine Zuleitung in den Stator gedrückt, dringt durch die poröse Platte, strömt langsam und gleichmäßig durch die Maschen des Gefüges und hebt dadurch den zu bewegenden Gegenstand.

K.S.J. Pister et al. berichten unter dem Titel "A planar air levitated electrostatic actuator system" in Proceedings of the IEEE Micro Electro Mechanical Systems Workshop, auf den Seiten 67 - 71, Napa Valley California Feb 11-14, 1990, über einen Mikromotor, der mehrere Gegenstände dreidimensional einige 100 µm bewegen kann. Dieser Ansatz ist für kurze Distanzen zur Bewegung von Bauteilen mit geringer Masse geeignet.

F. M. Moesner et al. berichten auf der IEEE Industry Application Society Conference Record, 31^{st} Annual Meeting San Diego, October, 1996 unter dem Titel "New considerations for traveling wave particle handling", (pp 1986-1993). Das Verfahren eignet sich nur zum Transport von sehr kleinen Partikeln, da das elektrische Feld die Teile sowohl anheben als auch vorwärts transportieren muß. Dieses Verfahren ist für größere Bauteile nicht anwendbar, da die Kräfte dann nicht mehr ausreichen die Schwerkraft zu überwinden.

Gegenstände mit quaderförmiger Plättchenform im unteren cm-Bereich, metallisch oder dielektrisch, auf einer Strecke von einem Magazinausgang beispielsweise bis zu einem Montageort berührungslos zu transportieren, gelingt mit den in den drei Literaturstellen beschriebene Einrichtungen nicht. Allenfalls kleine Körper bis zu 400 µm sind mit der Teilchenhandhabung auf der Basis der Wanderwellen nach Moesner et al. mit elektrischen Feldern zu transportieren.

Im Laufe von Forschungs- und Entwicklungsarbeiten zur Entwicklung von Mikromontagesystemen entstand der Bedarf empfindliche optische Komponenten mit Abmessungen im Millimeterbereich der Montage eines Mikrosystems zuzuführen. Konventionelle Linearförderer beschädigen diese Komponenten durch Abrasion. Daraus ergibt sich die Aufgabe, die der Erfindung zugrunde liegt, nämlich auch größere Gegenstände auf einer beliebig langen Wegstrecke störungsfrei und berührungslos bis zum Montageort vorwärts zu bewegen und dem Einbau zuzuführen.

Die Aufgabe wird durch eine elektronisch betriebene Fördereinrichtung für den berührungslosen Transport von dielektrischen Teilen bis hin zu elektrisch leitenden Bauteilen, also von Bauteilen aus Kunststoff, Halbleitermaterial oder Metall, gemäß den Merkmalen des Anspruchs 1 gelöst:

Die Transportbahn besteht zum einen aus einer mit Düsen versehenen Leiste, aus denen jeweils Luft oder ein geeignetes Gas nach oben abströmt und so entlang und über der Bahn ein Luftkissen zumindest für die Transportzeit bildet. Die Leiste kann zum andern auch aus gasporösem Material bestehen, dessen gleichverteilte Poren so groß sind, daß ein Luftkissen entlang und über der Transportbahn aufgebaut werden und das zu transportierende Bauteil ausreichend hoch anheben kann. Zur gezielten Luft- oder Gasströmung daraus können nicht notwendige Abströmbereiche, wie zur Seite exponierte Außenwände, durch Lack oder Kleber oder Folie oder sonstwie flächig in dünnen gasdichten Schichten aufbringbarem Material abgedeckt sein. In beiden Fällen bildet die Luft- oder Gaseintrittsfläche der Leiste oder der Leisten ein Teil der Innenwand des in seinem Druck steuerbaren Luft- oder Gasreservoirs.

Elektroden überbrücken die Transportbahn unter Bildung eines für den Transport der Bauteile mindestens notwendigen lichten Bereichs über der Transportbahn.

Die Elektroden sind an eine Multiplexereinrichtung angeschlossen und können darüber gruppenweise, mit mindestens zwei Elektroden pro Gruppe, mit jeweils einem definierten elektrischen Potential beaufschlagt werden. Diese elektrische Beaufschlagung schreitet vom Eingang der Transportbahn her zum Ausgang hin in Form einer Wanderwelle fort, Sie sind stets, vom Anfang des Bandes ausgehend, bis zum Ende fortlaufend, als mindestens eine Gruppe von mindestens zwei unmittelbar benachbarten mit einem jeweils definierten elektrischen Potential für das horizontale Vorwärtsbewegen der Bauteile beaufschlagbar, wobei der Abstand zweier unmittelbar benachbarter Elektroden kleiner oder etwa gleich der Ausdehnung des Bauteils in Transportrichtung ist, höchstens aber so groß, daß ein solches bei seiner Vorwärtsbewegung von der letzten Elektrode der unmittelbar in Front liegenden Elektrodengruppe elektrisch hinreichend beeinflußt und damit durch das elektrische Feld eine Zug- oder Schubkraft auf das Bauteil einwirken kann.

In den Unteransprüchen 2 bis 14 sind Merkmale aufgeführt, die den Transport vorteilhaft beeinflussen:

Die Leisten der Transportbahn haben einen Querschnitt, bei denen der nach oben weisende, luft- oder gasabströmende Bereich also, ein stumpfes v-förmiges Profil aufweist. Dem entsprechend läßt sich hinsichtlich des Strömungsdrucks ein durchgehendes Luftkissen über der Bahn aufbauen, das ein ähnliches Druckprofil aufweist. Für das sich vorwärts bewegende Bauteil besteht dann stets ein rücktreibender Einfluß von links und rechts, der die Vorwärtsbewegung stabilisiert (Anspruch 2).

In einer andern Transportbahnausführung ist die Bahn eben, die mindestens zwei parallelen Düsenreihen sind linienförmig und die Düsenabstände in Transportrichtung äquidistant. Im Fall der Transportbahn aus porösen Leisten ist wie oben die Porendichte gleichverteilt. Der Düsenabstand bei Düsenleisten ist derartig, daß pro Düsenreihe stets mindestens zwei aufeinanderfolgende Düsen vom kleinsten zu transportierenden Bauteil überdeckt werden. In Querrichtung zur Transportrichtung sind es mindestens zwei Düsen, die von diesem kleinsten Bauteil überdeckt werden. Je mehr Düsen beim Transport überdeckt werden, um so ruhiger ist die Lage des Bauteils während des Transports. Beim Aufbau der Transportbahn aus gasporösen Leisten muß die Porendichte entsprechend am kleinsten zu transportierenden Bauteil orientiert werden. Sie muß daher mindestens so groß sein, daß gerade eine stabile Lage des durch das Luft- oder Gaskissen angehobenen Bauteils besteht (Anspruch 3).

Zur Steuerung des Profils des Luftkissens quer zur Transportrichtung kann die Bahn aus Düsenleisten unterschiedlicher Düsenweite bestehen. Hierüber läßt sich dann mit dem einfachsten Aufbau der Transportbahn, nämlich der ebenen Bahn ein die Lage des Bauteils stabilisierendes Luftkissenprofil, z.B. die stumpfe V-Form, erzeugen. Sind die Leisten gasporös, dann ist dasselbe durch in Transportrichtung unterschiedlichem Grad der Porosität, z.B. zu Seite hin größer werdende Poren, der Porenleisten erreichbar (Anspruch 4).

Im einfachsten Aufbau der Fördereinrichtung besteht die Transportbahn aus Düsenleisten oder aus porösen Leisten, die mit ihrer Exposition nach oben eben liegen. Hierbei ist eine Kanalisierung gegeben, wenn die Bahn beidseitig von einer Begrenzungsbande eingefaßt ist (Anspruch 5). Bei ausreichender lichter Höhe können beide Begrenzungsbanden Auflage oder Verankerungseinrichtungen für die Elektroden sein.

Um die Traktion des sich auf der Transportbahn befindlichen Bauteils über elektrische Einwirkung durch die von den Elektrodengruppen ausgehende Feldanordnung durch elektrischen Einfluß von reiner Polarisation bei Dielektrika bis hin zu reiner Ladungstrennung bei elektrisch gut leitfähigen Bauteilen zustande zu bringen, unterscheidet sich das jeweilige elektrische Potential einer Elektrode von den Elektroden einer Gruppe von dem der unmittelbar benachbarten, um lokal solche Effekte zu erzielen (Anspruch 6).

Eine einfache, monotone Abstufung ist einerseits, Anspruch 7, wenn das elektrische Potential der Elektroden einer Gruppe von der in Transportrichtung vordersten zu der hintersten hin abnimmt oder andrerseits, Anspruch 8, das elektrische Potential der Elektroden einer Gruppe von der in Transportrichtung vordersten zu der hintersten hin zunimmt. Die elektrische Einwirkung von einer Gruppe her ist dann gewissermaßen gleichgerichtet.

Um Bauteile ab dem Eintritt in die Fördereinrichtung gezielt zu beschleunigen und kurz vor dem Austritt daraus gezielt abzubremsen, haben die Elektroden in diesen Bereichen einen Elektrodenabstand, der kleiner ist als im Zwischenbereich, wo sich das Bauteil mit einer Sollgeschwindigkeit vorwärts bewegt.

Oben wurde schon beschrieben, daß die Elektroden bei vorhandenen Seitenbanden unter Freilassen eines lichten Durchtrittsbereichs die Transportbahn stegförmig überbrücken. Ist eine solche seitliche Transportbahnbegrenzung nicht vorhanden, dann sind die Elektroden entsprechend bügel- oder bogenartig gebogen und überspannen dann mit notwendiger lichten Weite das Förderband (Anspruch 10).

Während vorausgehender Untersuchungen zeigte sich, daß die Querschnittsform der Elektroden nicht einflusslos ist. In Anspruch 11 sind daher gerade polygonale, d.h. ab Dreiecksform in der Eckenzahl aufwärts, oder runde Querschnitte, wie Kreis, Ellipse bzw. Oval, oder gemischte Formen davon, wie Linsenform, Kreis-, Ellipsen-, Parabel, Hyperbelsegmentform, gekennzeichnet.

Ein weiterer, technisch bedeutender Gesichtspunkt ist die Registrierung und Lokalisierung des oder der auf dem Förderband gerade sich befindlichen oder sich gerade vorwärts bewegenden Bauteils oder Bauteile. Kann das erfaßt werden, so ist daraus, falls notwendig ein Steuer- oder auch Regelsignal zur Bewegungsoptimierung ableitbar. Solche Einrichtungen sind ihrem Prinzip nach sukzessive in den Ansprüchen 12 bis 14 beschrieben. Das ist zum einen:
Quer zum Förderband befinden sich Lichtschranken zur Detektion, mit denen ein gerade durch den Lichtstrahl tretendes Bauteil durch Unterbrechung geortet;
Zum andern:
Entlang zum Förderband reihen sich wie die Elektroden kapazitive Einrichtungen auf. Im einfachsten Fall zwei einander gegenüberliegende, jeweils seitlich der Bahn aufgestellte Kondensatorplatten. Ein gerade durch diesen zwischen den beiden Platten liegenden Bereich durchtretendes Bauteil ändert die Kapazität; und schließlich:
Eine optoelektronische Bildaufnahmeeinrichtung aus mindestens einer Aufnahmekamera nimmt den Bereich der Förderbahn in Draufsicht auf. In einer angeschlossenen Datenverarbeitungsanlage wird von der Förderbahn oder dem Transportband selber eine Bildelementfolge (Pixelfolge in der Fachsprache) abgelegt und auf das Bildmuster eines Bauteils hin ständig abgetastet. Tritt ein solches Muster tatsächlich auf wird es geortet und daraus mit Hilfe dieser Datenverarbeitungseinrichtung ein weiter verwendbares Nutzsignal für die oben erwähnten Belange abgeleitet.

Die Trennung der Levitation - Hebung durch das Luftkissen - vom Vorschub - Vorwärtsbewegung durch ein elektrisches Wanderfeld - ermöglicht den Transport über eine beliebige Länge von erheblich größeren Teilchen im oberen mm- bis unteren cm-Bereich. Die leiterartige Anordnung der Elektroden über dem Förderkanal bzw. der Düsenplatte hat zur Folge, daß die Vertikalkomponente der elektrostatischen Anziehung in der gleichen Richtung wie die Levitationskraft des Luftkissens wirkt und damit der Levitation zumindest nicht entgegenwirkt. Die Luftlagerung des Transportgutes, abhängig vom spezifischen Gewicht und Volumen der Transportteile, ist so wesentlich leichter einzustellen und zu stabilisieren. Die Fördereinrichtung ermöglicht den Transport empfindlicher makroskopischer Bauteile über eine grundsätzlich beliebig lange Strecke. Dabei muß die Förderstrecke nicht gerade sein. Sie kann mit nicht zu kleinen Krümmungsradius von der geraden Form abweichen, solange die Transportbahnposition aufrechterhalten werden kann. Sie kann auch aus nicht fluchtenden geraden Abschnitte bestehen, die am jeweiligen Knickpunkt die Umlenkung zulassen müssen. Die Möglichkeit der Wahl der Pulsform der Hochspannungspulse an die gerade anzusteuernde Elektrodengruppe verschafft mit dem aus der Registrierung bzw. Lokalisierung abgeleiteten Signal weiter die Möglichkeit, den Transport abhängig von Gewicht und Volumen mit hoher Geschwindigkeit und keiner oder allenfalls minimaler, d.h. unvermeidlicher Überschwingung einzurichten.

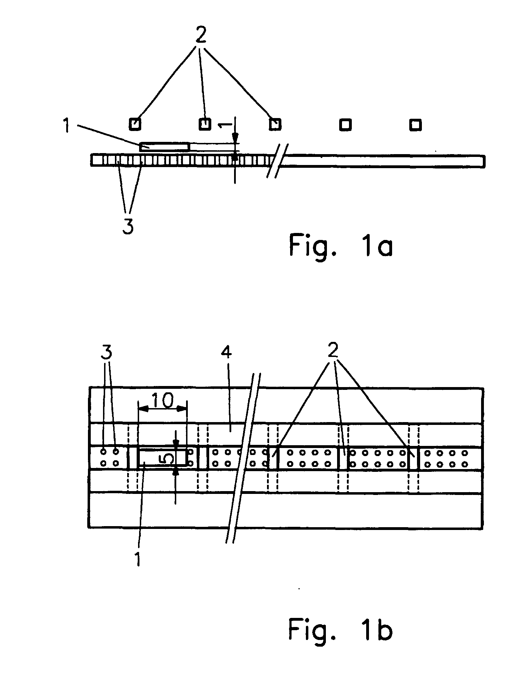

Die Erfindung wird in folgendem anhand der Zeichnung näher erläutert. Die Zeichnung besteht aus den Figuren 1 bis ?. Sie zeigen:
- Figur 1a: den prinzipiellen Aufbau des Elektrostatikförderers,
- Figur 1b: die Seitenansicht davon,
- Figur 2: der prinzipielle Ablauf der Förderbewegung,
- Figur 3: die Hardwarekomponenten der Elektrodenansteuerung,
- Figur 4: die Aufnahme einer Förderbewegung.

Mit dem derzeit realisierte Prototypen können plattenförmige Kunststoff- und Metallbauteile mit den Dimensionen von typischerweise 10 x 5 x 1 mm³ bis 6 x 5 x 1 mm³ transportiert werden. Diese Maße sind beispielhaft und sollen den Ausdehnungsbereich der zu transportierenden Bauteile veranschaulichen.

Die Transportbahn oder der Förderweg (Figur 1a und b) besteht hier aus einer Platte aus keramischem Material, Al₂O₃-Keramik, beispielsweise, mit hier fünf, zueinander parallelen, im vorgegebenen Abstand zueinander liegenden Reihen gleichartiger Düsen. Die Düsenreihen sind gegeneinander versetzt, und zwar so, daß eine beliebige Düse aus einer Düsenreihe zwischen zwei Düsen der Nachbarreihe zum liegen kommt. Diese Düsenplatte deckt das Reservoir der Luft/Gasversorgung ab. Der Luft/Gasstrom durch die Düsen ist in seinem Druck steuerbar.

Die Transportbahn wird durch zwei Führungsleisten links und rechts der Düsenbahn in vorgegebenem Abstand und spiegelbildlich zueinander bezüglich der Längsachse begrenzt. Sie bilden mit der Transportbahn den Förderkanal. Über dem Förderkanal ist die leiterartige Anordnung der Elektroden. Sie überspannen die Bahn stegartig gerade und sind in den Führungsleisten verankert, von wo sie an die Hochspannungsversorgung mit einem dazwischen liegenden Multiplexer angeschlossen sind.

Eine Elektrodengruppe besteht aus zwei Elektroden. Am Steuereingang der Relaisschaltung oder des Multiplexers liegt der digitale Ausgang der Digital/Analogwandlerkarte. Ihr analoger Ausgang ist an den Eingang eines Hochspannungsverstärkers gelegt ist. Die gesamte Einrichtung ist mit einem elektronischen Rechner verbunden. So liegt der Rechnerausgang am Eingang der Digital/Analogwandlerkarte.

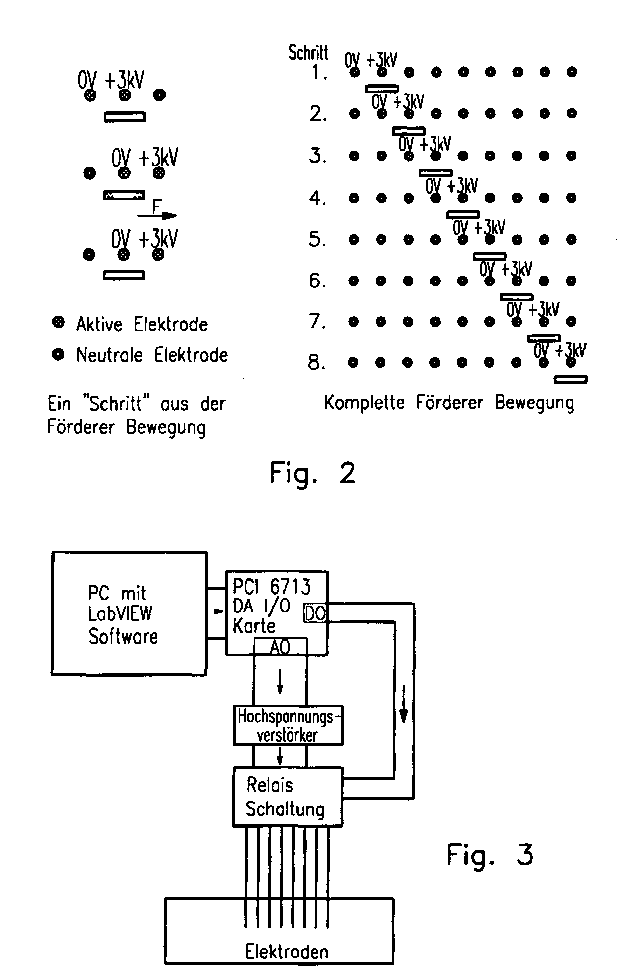

Das Funktionsprinzip arbeitet folgendermaßen: die in Transportrichtung vorne liegende Elektrode einer Gruppe wird an 2500 V gelegt, die zweite oder hintere Elektrode liegt auf Masse, 0 V (Figur 2, Schritt 1). Durch das erzeugte elektrische Feld entsteht bei Bauteilen aus dielektrischen Werkstoffen eine lokale Polarisation (bei metallischen Bauteilen eine echte Ladungstrennung durch Influenz). Das Bauteil wird damit zum Dipol und wird durch die Kräfte im elektrischen Feld angezogen bzw. abgestoßen. Schaltet man die Hochspannung nun immer um eine Elektrode weiter, d.h. die Gruppe wandert stets um eine Elektrode weiter, so wird das Bauteil durch das elektrische Feld in der Förderrinne vorwärts transportiert (Fig. 2, Schritte 2 - 8).

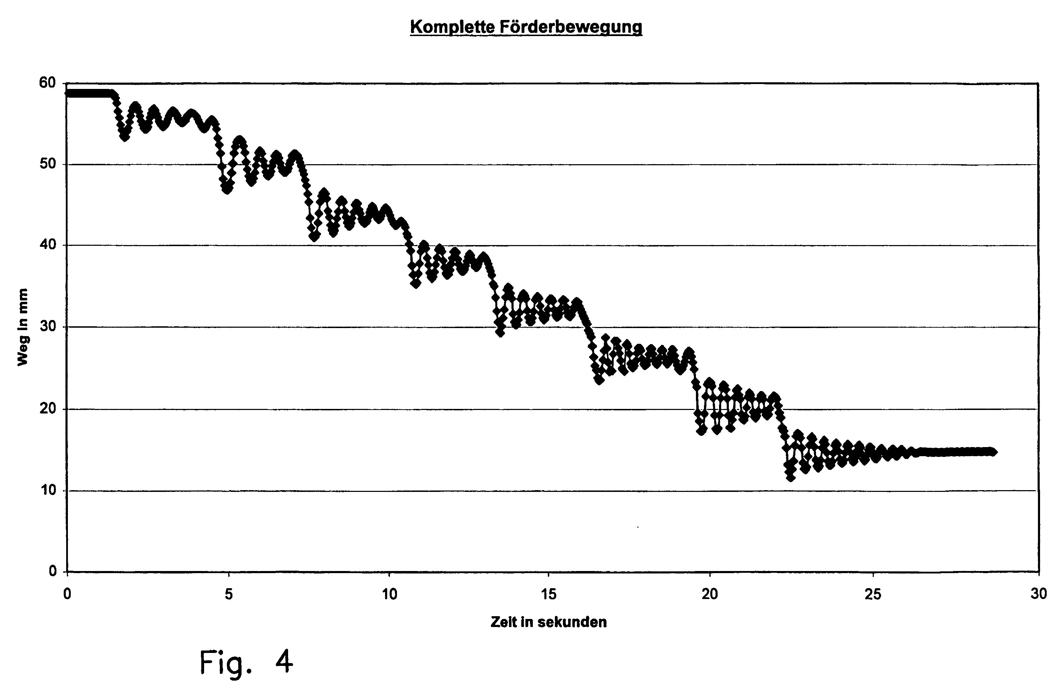

Den zeitlichen Verlauf der Bewegung der Kunststoffplatte in der Förderrinne zeigt Fig. 4. Sie wurde mit dem Bildverarbeitungssystem gemäß Anspruch 14 aufgezeichnet. Zunächst wird das Plättchen in der Aufladeposition polarisiert, anschließend erfolgen die ersten drei Schritte. Das elektrische Feld führt zunächst zu einer hohen Anfangsbeschleunigung. Danach schwingt das Plättchen langsam, durch die Luftlagerung schwach gedämpft, aus. Zur Erzeugung des elektrischen Feldes dient das Hochspannungnetzteil oder, falls nötig, mehrere Hochspannungsnetzteile, mit einer Eingangsspannung von 0-12 V und einer Ausgangsspannung von 0-2,5kV. Über ein institutintern erarbeitetes Programm können auf die Analogausgänge der D/A-Wandlerkarte verschiedene Funktionen, wie Sinus, Rechteckimpuls, Sägezahn, cos², Gauß-Impuls etc., ausgegeben werden, die über die Zwischenelektronik und die Hochspannungsnetzteile schließlich in entsprechende Hochspannungsverläufe umgesetzt werden. Die Hochspannungnetzteile werden über die Anpassungselektronik von dem PC über die D/A-Wandlerkarte angesteuert. Der Multiplexer oder Relaisschaltkreis schaltet die Elektroden der Gruppen an das jeweilige Potential. Dabei können die Gruppen hinsichtlich der Elektroden unterbrechungslos aufeinander folgen oder aber es liegt zwischen zwei aufeinander folgenden Gruppen mindestens eine Elektrode auf Masse. Das ist eine steuerungstechnische Angelegenheit, die sich am optimalen Bauteiletransport orientiert (Fig. 3).

Die Erläuterung ist hier auf eine einzige geradlinig ausgerichtete Bahn beschränkt. Erweiterungen bezüglich der Aneinanderreihung von Förderkanälen geht mit zusätzlichen Hochspannungsnetzteilen und Relaisschaltungen einher. Die Verknüpfung gemäß Figur 3 erfolgt entsprechend und einfach linear erweitert. Das hat den maßgeblichen Vorteil, daß eine solche Fördereinrichtung bis auf den Förderkanal aus bekannten, standardisierten Baugruppen aufgebaut werden kann, was bei der bekannten Rechnerkapazität allenfalls nur eine Erhöhung der Anzahl Hochspannungsnetzteile und Relaisschaltungen bedeutet.

## Patentansprüche

1. Fördereinrichtung für den berührungslosen Transport von Bauteilen (1) aus Kunststoff, Halbleitermaterial oder Metall, bestehend aus: einer Multiplexeinrichtung, an die die Elektroden (2) angeschlossen sind und, in Form einer Wanderwelle fortschreitend, stets vom Anfang des Bandes ausgehend, bis zum Ende fortlaufend, mindestens eine Gruppe von mindestens zwei unmittelbar benachbarten mit einem jeweils definierten elektrischen Potential für das horizontale Vorwärtsbewegen der Bauteile beaufschlagbar sind, wobei der Höchstastand zweier unmittelbar benachbarter Elektroden (2) höchstens gleich der Ausdehnung des Bauteils (1) in Transportrichtung ist, **dadurch gekennzeichnet daß** die Fördereinrichtung aus :
- einer Transportbahn aus mindestens einer mit Düsen versehenen Leiste oder mindestens einer Leiste aus gasporösem Material zur Erzeugung eines bahnförmigen Luftkissens zum Anheben auf der Transportbahn befindlicher Bauteilen (1), wobei die Bahn (4) an ein im Druck steuerbares Luftoder Gasreservoir angebaut ist,
einer Reihe aus Elektroden (2), die quer zur Transportbahn unter Einrichtung eines für den Transport der Bauteile (1) mindestens notwendigen lichten Bereichs über dem Düsenband ragen, besteht.

2. Fördereinrichtung nach Anspruch 1,
**dadurch gekennzeichnet, dass**
die Bahn (4) im Querschnitt ein stumpfes v-förmiges oder rinnenförmiges Profil aufweist, die Düsen gleichverteilt oder linienförmig längs der Bahn (4) angeordnet oder die Poren gleichverteilt sind und damit bei Durchströmung des Gases das Luftkissen ein ebensolches oder ähnliches Profil aufweist.

3. Fördereinrichtung nach Anspruch 1,
**dadurch gekennzeichnet, dass**
die Bahn (4) eben ist, die Düsen (3) gleichverteilt oder Iinienförmig längs der Bahn (4) angeordnet oder die Poren gleichverteilt sind und damit bei Durchströmung des Gases das Luftkissen ein ebensolches oder ähnliches Profil aufweist.

4. Fördereinrichtung nach Anspruch 1,
**dadurch gekennzeichnet, dass**
die Bahn (4) aus Bändern oder Leisten mit Düsen (3) unterschiedlichen Durchmessers oder aus nebeneinander angeordneten Leisten unterschiedlicher Porosität besteht, so daß bei Durchströmung mit Gas darüber ein Luftkissen mit stumpfem v-förmigem Querschnitt entsteht.

5. Fördereinrichtung nach den Ansprüchen 2 bis 4,
**dadurch gekennzeichnet, dass**
die Bahn (4) beidseitig von einer Begrenzungsbande eingefaßt ist.

6. Fördereinrichtung nach Anspruch 5,
**dadurch gekennzeichnet, dass**
sich das jeweilige elektrische Potential einer Elektrode (2) von den Elektroden (2) einer Gruppe von dem der unmittelbar benachbarten unterscheidet.

7. Fördereinrichtung nach Anspruch 6,
**dadurch gekennzeichnet, dass**
das elektrische Potential der Elektroden (2) einer Gruppe von der in Transportrichtung vordersten zu der hintersten hin abnimmt.

8. Fördereinrichtung nach Anspruch 6,
**dadurch gekennzeichnet, dass**
das elektrische Potential der Elektroden (2) einer Gruppe von der in Transportrichtung vordersten zu der hintersten hin zunimmt.

9. Fördereinrichtung nach den Ansprüchen 7 und 8,**dadurch gekennzeichnet, dass**
der Elektrodenabstand im Anfangsbereich, dem Beschleunigungsbereich, und Endbereich, dem Bremsbereich, der Transportbahn kleiner ist als im Zwischenbereich.

10. Fördereinrichtung nach Anspruch 9,
**dadurch gekennzeichnet, dass**
die Elektroden (2) über der Transportbahn diese steg- oder bügelartig überbrücken.

11. Fördereinrichtung nach Anspruch 9,
**dadurch gekennzeichnet, daß**
die Elektroden (2) einen polygonalen oder runden Querschnitt mit Ecken oder einen bereichsweise runden Querschnitt mit mindestens einem Sehnenbereich haben.

12. Fördereinrichtung nach einem der Ansprüche 10 bis 11,
**dadurch gekennzeichnet, daß**
sich quer zur Bahn (4) Lichtschranken zur Detektion befinden, mit denen ein gerade transportiertes Bauteil (1) lokalisiert, sein Durchgang registriert und daraus zur Transportoptimierung ein Regelsignal abgeleitet werden kann.

13. Fördereinrichtung nach einem der Ansprüchen 10 bis 12,
**dadurch gekennzeichnet, daß**
sich quer zur Bahn (4) kapazitive Einrichtungen zur Detektion befinden, mit denen ein gerade transportiertes Bauteil (1) lokalisiert, sein Durchgang registriert und daraus zur Transportoptimierung ein Regelsignal abgeleitet werden kann.

14. Fördereinrichtung nach einem der Ansprüche 10 bis 13,
**dadurch gekennzeichnet, dass**
eine optoelektronische Bildaufnahmeeinrichtung die Transportbahn (4) in Draufsicht aufnimmt, die Folge der Bildelemente von der Transportbahn in einer angeschlossenen Datenverarbeitungsanlage abgelegt sind und während des Betriebs auf das Vorhandensein des vor dem Transport aufgenommen Bildelementmusters eines der zu transportierenden Bauelemente (1) abgetastet wird, so daß ein gerade transportiertes Bauteil (1) lokalisiert, sein Durchgang registriert und daraus zur Transportoptimierung ein Regelsignal abgeleitet werden kann.

## Claims

1. Conveying apparatus for the contactless conveyance of components (1) formed from plastics material, semiconductor material or metal, said apparatus comprising a multiplexing means, with which the electrodes (2) communicate, and at least one group of at least two directly adjacent electrodes, advancing in the form of a travelling wave, always starting from the beginning of the band and continuing to the end, can be acted upon with a respectively defined electric potential for the horizontal forward displacement of the components, the maximum spacing between two directly adjacent electrodes (2) being, at most, identical to the dimension of the component (1) when viewed with respect to the direction of conveyance, **characterised in that** the conveying apparatus comprises:
- a conveyor belt formed from at least one strip, which is provided with nozzles, or at least one strip formed from gas-porous material to produce a belt-like air cushion for raising components (1) situated on the conveyor belt, the belt (4) being attached to an air or gas reservoir which is controllable by pressure, and
- a number of electrodes (2), which protrude above the band of nozzles transversely relative to the conveyor belt by establishing an unobstructed region which is at least necessary for the conveyance of the components (1).

2. Conveying apparatus according to claim 1, **characterised in that** the belt (4) has a truncated V-shaped or groove-like profile in cross-section, the nozzles are evenly distributed or disposed linearly along the belt (4), or the pores are evenly distributed and, in consequence, the air cushion has an identical or similar profile when traversed with the gas.

3. Conveying apparatus according to claim 1, **characterised in that** the belt (4) is flat, the nozzles (3) are evenly distributed or disposed linearly along the belt (4), or the pores are evenly distributed and, in consequence, the air cushion has an identical or similar profile when traversed with the gas.

4. Conveying apparatus according to claim 1, **characterised in that** the belt (4) comprises bands or strips having nozzles (3) of variable diameter or strips of variable porosity which are disposed one beside the other, so that an air cushion is produced with a truncated V-shaped cross-section when traversed with gas.

5. Conveying apparatus according to claims 2 to 4, **characterised in that** the belt (4) is bordered at both ends by a boundary edge.

6. Conveying apparatus according to claim 5, **characterised in that** the respective electric potential of an electrode (2) from the electrodes (2) of a group differs from that of the directly adjacent electrode.

7. Conveying apparatus according to claim 6, **characterised in that** the electric potential of the electrodes (2) of a group decreases from the foremost electrode to the rearmost electrode when viewed with respect to the direction of conveyance.

8. Conveying apparatus according to claim 6, **characterised in that** the electric potential of the electrodes (2) of a group increases from the foremost electrode to the rearmost electrode when viewed with respect to the direction of conveyance.

9. Conveying apparatus according to claims 7 and 8, **characterised in that** the spacing between the electrodes in the initial region, the acceleration region, and in the end region, the retarding region, of the conveyor belt is smaller than in the intermediate region.

10. Conveying apparatus according to claim 9, **characterised in that** the electrodes (2) above the conveyor belt span said belt in a web- or clamp-like manner.

11. Conveying apparatus according to claim 9, **characterised in that** the electrodes (2) have a polygonal or round cross-section with comers or a cross-section which is round in various regions and has at least one chordal region.

12. Conveying apparatus according to one of claims 10 to 11, **characterised in that** light barriers for detection purposes are situated transversely relative to the belt (4), by means of which light barriers a rectilinearly conveyed component (1) can be localised, its passage can be recorded, and a regulating signal can be derived therefrom to optimise conveyance.

13. Conveying apparatus according to one of claims 10 to 12, **characterised in that** capacitive detecting means are situated transversely relative to the belt (4), by means of which means a rectilinearly conveyed component (1) can be localised, its passage can be recorded, and a regulating signal can be derived therefrom to optimise conveyance.

14. Conveying apparatus according to one of claims 10 to 13, **characterised in that** an optoelectronic picture taking means takes a picture of the conveyor belt (4) in plan view, the sequences of the picture elements of the conveyor belt are stored in a subsequent data processing system, and one of the components (1) to be conveyed is scanned, during the operation, for the presence of the picture element pattern taken prior to the conveyance, so that a rectilinearly conveyed component (1) can be localised, its passage can be recorded, and a regulating signal can be derived therefrom to optimise conveyance.

## Revendications

1. Dispositif de transport sans contact d'éléments (1) en plastique, en matériau semi-conducteur ou en métal, comprenant un dispositif multiplex auquel sont raccordées des électrodes (2) dont, sous la forme d'une onde progressive avançant continuellement, en partant du début de la bande jusqu'à l'autre extrémité, au moins un groupe d'au moins deux électrodes directement voisines sont soumises pour le déplacement horizontal des éléments vers l'avant à un potentiel électrique défini respectivement, la distance la plus élevée entre les deux électrodes (2) directement voisines étant au plus égale à la dilatation de l'élément (1) dans la direction de transport,
**caractérisé en ce que**
le dispositif de transport comprend :
une bande transporteuse avec au moins une bordure équipée de filières ou au moins une bordure réalisée en matériau poreux aux gaz pour obtenir un coussin d'air en forme de bande destiné à soulever les éléments (1) se trouvant sur la bande transporteuse, la bande (4) étant intégrée à un réservoir de gaz ou d'air contrôlable sous pression, et
une série d'électrodes (2) qui dépassent au-dessus de la bande de filières transversalement à la bande transporteuse par un dispositif avec au moins une zone libre, nécessaire au transport des éléments (1).

2. Dispositif de transport selon la revendication 1,
**caractérisé en ce que**
la bande (4) présente en coupe transversale un profil en forme de V tronqué ou en forme de gouttière, les filières sont régulièrement réparties ou disposées linéairement le long de la bande (4) ou les pores sont régulièrement répartis afin que, lors de l'écoulement du gaz, le coussin d'air présente un profil quasi plat ou analogue.

3. Dispositif de transport selon la revendication 1,
**caractérisé en ce que**
la bande (4) est plate, les filières (3) sont régulièrement réparties ou disposées linéairement le long de la bande (4) ou les pores sont régulièrement répartis, afin que, lors de l'écoulement du gaz, le coussin d'air présente un profil quasi plat ou analogue.

4. Dispositif de transport selon la revendication 1,
**caractérisé en ce que**
la bande (4) comprend des courroies ou des bordures avec des filières (3) de diamètres différents ou comprend des bordures de porosité différente disposées les unes à côté des autres de telle sorte que, lors de l'écoulement du gaz, un coussin d'air avec une section en forme de V tronqué se forme dessus.

5. Dispositif de transport selon les revendications 2 à 4,
**caractérisé en ce que**
la bande (4) est entourée des deux côtés par une courroie de délimitation.

6. Dispositif de transport selon la revendication 5,
**caractérisé en ce que**
le potentiel électrique respectif d'une électrode (2) appartenant aux électrodes (2) d'un groupe se différencie du potentiel de celles qui sont directement voisines.

7. Dispositif de transport selon la revendication 6,
**caractérisé en ce que**
le potentiel électrique des électrodes (2) d'un groupe diminue de la première électrode dans la direction de transport à la dernière.

8. Dispositif de transport selon la revendication 6,
**caractérisé en ce que**
le potentiel électrique des électrodes (2) d'un groupe augmente de la première électrode dans la direction à la dernière.

9. Dispositif de transport selon les revendications 7 et 8,
**caractérisé en ce que**
la distance de la bande transporteuse entre les électrodes dans la zone initiale, la zone d'accélération et la zone terminale, la zone de freinage, est plus petite que dans la zone intermédiaire.

10. Dispositif de transport selon la revendication 9,
**caractérisé en ce que**
les électrodes (2) sur la bande transporteuse surplombent celle-ci sous la forme d'une passerelle ou sous la forme d'un étrier.

11. Dispositif de transport selon la revendication 9,
**caractérisé en ce que**
les électrodes (2) ont une section polygonale ou arrondie avec des coins ou une zone de section arrondie avec au moins une zone de maillons.

12. Dispositif de transport selon une des revendications 10 à 11,
**caractérisé en ce que**
des barrages de détection optiques sont situés transversalement à la bande (4), avec lesquels un élément (1) tout juste transporté peut être localisé, son passage enregistré et, pour optimiser son transport, un signal de contrôle peut être émis.

13. Dispositif de transport selon une des revendications 10 à 12,
**caractérisé en ce que**
des dispositifs capacitifs de détection sont situés transversalement à la bande (4), avec lesquels un élément (1) tout juste transporté peut être localisé, son passage enregistré et, pour optimiser son transport, un signal de contrôle peut être dérivé.

14. Dispositif de transport selon une des revendications 10 à 13,
**caractérisé en ce que**
un dispositif optoélectronique de réception d'images présente une vue de dessus de la bande transporteuse (4), les séquences d'éléments-images de la bande transporteuse sont déposées dans un dispositif de traitement de données raccordé et, pendant le fonctionnement, la présence de l'échantillon de l'élément-image reçu avant le transport d'un des éléments (1) à transporter est détectée de telle sorte qu'un élément (1) tout juste transporté est localisé, son passage enregistré et, pour optimiser son transport, un signal de contrôle peut être émis.
